# EUROPÄISCHE PATENTSCHRIFT

(11) **EP 1 540 821 B1**
(45) Veröffentlichungstag und Bekanntmachung des Hinweises auf die Patenterteilung: **15.02.2006**
(21) Anmeldenummer: 03798049.7
(22) Anmeldetag: 31.07.2003
(51) Int. Cl.: H03K 5/19, H03K 5/08, G01D 1/02

(54) **SCHALTUNGSANORDNUNG ZUR MITTELWERTBILDUNG**
CIRCUIT CONFIGURATION FOR AVERAGING
CIRCUIT POUR ETABLIR DES MOYENNES

(30) Priorität: 19.09.2002 DE 10243564
(43) Veröffentlichungstag der Anmeldung: 15.06.2005
(73) Patentinhaber: SIEMENS AKTIENGESELLSCHAFT, 80333 München (DE)
(72) Erfinder: MEIER, Bernd, 92353 Postbauer-Heng (DE); VÖLKL, Peter, 93173 Wenzenbach (DE)
(86) Internationale Anmeldenummer: PCT/DE2003/002580
(87) Internationale Veröffentlichungsnummer: WO 2004/030211

(56) Entgegenhaltungen:
- EP-A- 0 367 522
- EP-A- 0 804 038
- US-A- 5 142 286
- US-A- 5 329 281
- PATENT ABSTRACTS OF JAPAN vol. 016, no. 420 (E-1259), 4. September 1992 (1992-09-04) -& JP 04 144423 A (JEOL LTD), 18. Mai 1992 (1992-05-18)

## Beschreibung

Die Erfindung betrifft eine Schaltungsanordnung zur Mittelwertbildung gemäß dem Oberbegriff des Anspruchs 1.

Gattungsgemäße Schattungsanordnunggen sind aus den Dokumenten EP-A-0 804 038, US-A-5 329 281 und EP-A-0 367 522 bekannt.

In der Kraftfahrzeugtechnik werden zur Steuerung eines automatischen Getriebes bekanntermaßen Magnetventile eingesetzt, die mit einem pulsweitenmodulierten Stromsignal angesteuert werden. Hierbei wird der zeitliche Mittelwert des Stroms erfasst, um das Regelverhalten des Magnetventils innerhalb einer Regelstrecke optimieren zu können.

Hierzu werden bislang herkömmliche analoge Tiefpassfilter verwendet, die Wechselspannungsanteile aus dem Stromsignal weitgehend ausfiltern und den Gleichanteil als Mittelwert ausgeben.

Nachteilig an der bekannten Mittelwertbildung durch analoge Filter ist zum einen die Einschwingzeit derartiger Filter, so dass der Mittelwert in der Regel erst nach einigen Perioden der Pulsweitenmodulation zur Verfügung steht.

Zum anderen ist die Mittelwertbildung durch analoge Filter auch relativ ungenau, was ebenfalls unerwünscht ist.

Der Erfindung liegt also die Aufgabe zugrunde, eine Schaltungsanordnung zu schaffen, die eine möglichst schnelle und genaue Mittelwertbildung ermöglicht.

Die Aufgabe wird, ausgehend von einer bekannten Schaltungsanordnung gemäß dem Oberbegriff des Anspruchs 1, durch die kennzeichnenden Merkmale des Anspruchs 1 gelöst.

Die Erfindung umfasst die allgemeine technische Lehre, zwischen dem Signaleingang und dem Signalausgang der Schaltungsanordnung einen Summierer oder einen Zähler für die Mittelwertbildung vorzusehen.

Vor der eigentlichen Mittelwertbildung wird das auszuwertende Eingangssignal also vorzugsweise zunächst digitalisiert, so dass die Mittelwertbildung ohne die dynamischen Probleme analoger Filter im Digitalbereich erfolgen kann.

In einer bevorzugten Ausführungsform der Erfindung ist der Summierer bzw. Zähler eingangsseitig mit einem Sigma-Delta-Modulator verbunden, der das auszuwertende Eingangssignal einer Sigma-Delta-Modulation unterzieht und das auf diese Weise modulierte Signal dem Summierer bzw. Zähler zuführt. Derartige Sigma-Delta-Modulatoren sind beispielsweise aus NORSWORTHY/SCHREIER/TEMES: "Delta-Sigma Data Converters" (IEEE Press), aus CANDY/TEMES: "Oversampling Delta-Sigma Data Converters : Theory, Design and Simulation" (IEEE Press) sowie aus ENGELEN/PLASSCHE: "Bandpass Sigma Delta Modulators" (Kluwer Academic Publishers) bekannt.

Der Sigma-Delta-Modulator sollte hierbei mit einer Taktfrequenz bzw. Abtastrate arbeiten, die größer als die Nyquist-Rate des Eingangssignals ist, damit eine Überabtastung erfolgt und keine Signalinformationen des Eingangssignals verloren gehen.

Bei einem periodischen Eingangssignal ist es weiterhin vorteilhaft, wenn stets dasselbe Zeitfenster des Eingangssignals ausgewertet wird. Dies ist sinnvollerweise die einfache oder vielfache Periodendauer des Eingangssignals. Der Zähler weist deshalb vorzugsweise einen Rücksetzeingang auf, dem ein Steuersignal zugeführt wird, das beispielsweise von einem Mikrocontroller erzeugt wird. Vorzugsweise stehen das Steuersignal und das auszuwertende Eingangssignal in einer zeitlich konstanten Phasenbeziehung zueinander, damit stets dasselbe Zeitfenster des Eingangssignals ausgewertet wird.

Bei einem periodischen Eingangssignal ist es weiterhin vorteilhaft, wenn das Eingangssignal und das Taktsignal des Sigma-Delta-Modulators in einer zeitlich konstanten Phasenbeziehung zueinander stehen, damit stets dasselbe Zeitfenster des Eingangssignals ausgewertet wird. Vorzugsweise wird das Eingangssignal für den Sigma-Delta-Modulator deshalb aus dem auszuwertenden Taktsignal abgeleitet, wozu beispielsweise ein herkömmlicher Mikrocontroller verwendet werden kann.

Weiterhin ist zu erwähnen, dass der Sigma-Delta-Modulator wahlweise analog oder digital ausgeführt sein kann.

Vorzugsweise weist der Sigma-Delta-Modulator eingangsseitig einen Addierer bzw. einen Subtrahierer, einen Integrator sowie ausgangsseitig einen Komparator auf, wobei der Ausgang des Komparators in einer Rückkopplungsschleife auf einen Eingang des Addierers bzw. Subtrahierers zurückgeführt ist.

Der Integrator des Sigma-Delta-Modulators kann beispielsweise als Integrator erster Ordnung ausgeführt sein, jedoch können auch Integratoren höherer Ordnung in dem Sigma-Delta-Modulator verwendet werden, wodurch sich vorteilhaft eine höhere Auflösung erreichen lässt.

Der ausgangsseitig in dem Sigma-Delta-Modulator angeordnete Komparator weist eine vorgegebene Entscheidungsschwelle auf, die vorzugsweise einem Nullpegel des Eingangssignals entspricht. Beim Überschreiten der Entscheidungsschwelle gibt der Komparator vorzugsweise einen positiven Pegel aus, wohingegen der Komparator beim Unterschreiten der Entscheidungsschwelle vorzugsweise einen negativen Pegel ausgibt.

In einer bevorzugten Ausführungsform der Erfindung wird der Ausgang des Komparators in der Rückkopplungsschleife nicht direkt auf den Eingang des Addierers bzw. Subtrahierers zurückgeführt, sondern zur Ansteuerung eines Schaltelements verwendet, das wahlweise ein erstes Referenzsignal oder ein zweites Referenzsignal auf den Eingang des Addierers bzw. Subtrahierers schaltet. Dies ist vorteilhaft, da das Ausgangssignal des Komparators Ungenauigkeiten aufweisen kann, die auf diese Weise nicht zurückgekoppelt und somit unterdrückt werden. Die Referenzsignale können dagegen durch Referenzsignalquellen mit hoher Genauigkeit und Konstanz erzeugt werden, so dass die Genauigkeit der Mittelwertbildung durch diese indirekte Rückkopplung erhöht wird.

In einer anderen, nicht beanspruchten Variante ist dagegen kein Sigma-Delta-Modulator erforderlich, wobei eingangsseitig ein Analog/Digital-Wandler vorgesehen ist, der das auszuwertende analoge Eingangssignal abtastet, in ein Digitalsignal umgewandelt und anschließend direkt oder indirekt dem Summierer bzw. dem Zähler zugeführt. Aus der Anzahl der vorangegangenen Abtastungen und dem Ausgangssignal des Summierers bzw. Zählers kann dann in einfacher Weise der zeitliche Mittelwert des Eingangssignals bestimmt werden, indem das Ausgangssignal des Summierers durch die Anzahl der aufaddierten Abtastwerte geteilt wird.

Der Analog/Digital-Wandler sollte hierbei ebenfalls mit einer Abtastrate arbeiten, die größer als die Nyquist-Rate des Eingangssignals ist, damit eine Überabtastung erfolgt und keine Signalinformationen des Eingangssignals verloren gehen.

Bei einem bandbegrenzten Eingangssignal mit einer vorgegebenen oberen Grenzfrequenz ist die Taktfrequenz des Analog/Digitalwandlers deshalb vorzugsweise ein ganzzahliges Vielfaches der Grenzfrequenz des auszuwertenden Eingangssignals, wobei eine Überabtastung mit einem Faktor von 16, 32 oder 64 vorteilhaft ist, um einen ausreichenden Signal/Rauschabstand zu erzielen.

Bei einem periodischen Eingangssignal ist es weiterhin vorteilhaft, wenn stets dasselbe Zeitfenster des Eingangssignals abgetastet wird. Der Summierer weist deshalb vorzugsweise einen Rücksetzeingang auf, dem ein Steuersignal zugeführt wird, das beispielsweise von einem Mikrocontroller erzeugt wird. Vorzugsweise stehen das Steuersignal und das auszuwertende Eingangssignal in einer zeitlich konstanten Phasenbeziehung zueinander, damit stets dasselbe Zeitfenster des Eingangssignals ausgewertet wird.

In den beiden vorstehend beschriebenen Varianten mit einem Sigma-Delta-Modulator einerseits und mit einem schneller Analog/Digital-Wandler andererseits ist ausgangsseitig vorzugsweise ein Ausgangsregister vorgesehen, dass den Mittelwert zwischenspeichert, bis der nächste Mittelwert berechnet wurde.

Die erfindungsgemäße Schaltungsanordnung eignet sich vorzugsweise zur Mittelwertbildung bei Strom- und Spannungssignalen in der Kraftfahrzeugtechnik. Beispielsweise kann das auszuwertende Eingangssignal - wie schon eingangs angedeutet wurde - ein Stromsignal sein, mit dem ein Magnetventil angesteuert wird.

Weiterhin ist zu erwähnen, dass die erfindungsgemäße Schaltungsanordnung nicht notwendigerweise als separate Schaltung ausgeführt sein muss. Es ist vielmehr auch möglich, dass die erfindungsgemäße Schaltungsanordnung Bestandteil einer komplexen elektronischen Schaltung ist, die neben der Mittelwertbildung auch andere Funktionen erfüllt.

Andere vorteilhafte Weiterbildungen der Erfindung sind in den abhängigen Ansprüchen enthalten oder werden nachstehend zusammen mit der Beschreibung der bevorzugten Ausführungsbeispiele der Erfindung anhand der Zeichnungen erläutert. Es zeigen:
- Figur 1: ein Schaltbild einer erfindungsgemäßen Schaltungsanordnung mit einem Sigma-Delta-Modulator zur Mittelwertbildung sowie
- Figur 2: ein Schaltbild einer alternativen Schaltungsanordnung mit einem schnellen Analog/Digital-Wandler anstelle eines Sigma-Delta-Modulators.

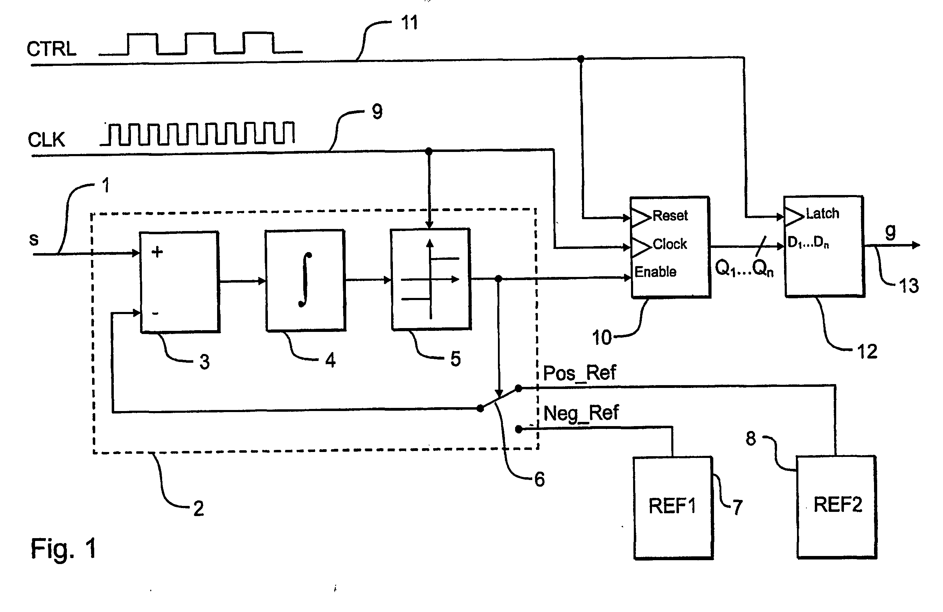

Die in Figur 1 dargestellte Schaltungsanordnung kann beispielsweise in einer elektronischen Getriebesteuerung eines Kraftfahrzeugs eingesetzt werden, um den zeitlichen Mittelwert eines Stromsignals s zu ermitteln.

Hierzu weist die erfindungsgemäße Schaltungsanordnung einen Signaleingang 1 auf, an dem das auszuwertende Stromsignal s anliegt.

Dem Signaleingang 1 ist ein Sigma-Delta-Modulator 2 nachgeschaltet, der analog aufgebaut ist und aus einem Addierer 3, einem Integrator 4 und einem Komparator 5 besteht.

Der Addierer 3 weist einen nicht-invertierenden Eingang auf, der mit dem Signaleingang 1 der erfindungsgemäße Schaltungsanordnung verbunden ist und das Eingangssignal s aufnimmt.

Weiterhin weist der Addierer 3 einen invertierenden Eingang auf, der über ein Schaltelement 6 wahlweise mit einer von zwei Referenzsignalquellen 7, 8 verbunden werden kann. Die Referenzsignalquelle 7 erzeugt hierbei ein Referenzsignal Neg_Ref mit einer negativen Polarität, wohingegen die Referenzsignalquelle 8 ein Referenzsignal Pos_Ref mit einer positiven Polarität erzeugt.

Die Ansteuerung des Schaltelements 6 erfolgt in Abhängigkeit von dem Signal, das am Ausgang des Komparators 5 erscheint. Hierzu weist das Schaltelement 6 einen Steuereingang auf, der mit dem Ausgang des Komparators 5 verbunden ist.

Falls das Ausgangssignal des Komparators 5 eine positive Polarität aufweist, so verbindet das Schaltelement 6 den invertierenden Eingang des Addierers 3 mit der Referenzsignalquelle 8.

Falls das Ausgangssignal des Komparators 5 dagegen eine negative Polarität aufweist, so verbindet das Schaltelement 6 den invertierenden Eingang des Addierers 3 mit der Referenzsignalquelle 7.

Diese indirekte Rückkopplung des Komparatorausgangs auf den invertierenden Eingang des Addierers bietet gegenüber einer direkten Rückkopplung den Vorteil, dass die Referenzsignalquellen 7, 8 ein wesentlich genaueres und zeitliches konstanteres Signal erzeugen können, wohingegen das Ausgangssignal des Komparators 5 Ungenauigkeiten aufweist.

Ausgangsseitig ist der Addierer 3 mit dem Eingang des Integrators 4 verbunden, wobei der Integrator 4 ein Integrator erster Ordnung ist, um eine einfache schaltungstechnische Realisierung zu ermöglichen.

Der Integrator 4 ist ausgangsseitig wiederum mit dem Komparator 5 verbunden, der das Ausgangssignal des Integrators 4 mit einer Entscheidungsschwelle vergleicht, die einem Null-Pegel des Eingangssignals s entspricht.

Beim Überschreiten der Entscheidungsschwelle gibt der Komparator 5 ein Ausgangssignal mit einer positiven Polarität aus, so dass der Schalter 6 den invertierenden Eingang des Addierers 3 mit der Referenzsignalquelle 8 verbindet.

Beim Unterschreiten der Entscheidungsschwelle gibt der Komparator 6 dagegen ein Ausgangssignal mit einer negativen Polarität aus, so dass der Schalter 6 den invertierenden Eingang des Addierers 3 mit der Referenzsignalquelle 7 verbindet.

Die Ansteuerung des Schalters 6 und eines Zählers 10 durch den Komparator 5 erfolgt hierbei taktgesteuert durch ein Taktsignal CLK, das von einem Mikrocontroller erzeugt wird und an einem Takteingang 9 anliegt. Die Taktfrequenz f_{CLK} des Taktsignals CLK ist hierbei 2ⁿ mal so groß wie die Grenzfrequenz fₛ des bandbegrenzten Eingangssignals s, wobei n ganzzahlig und größer oder gleich 1 ist. Dies ist sinnvoll, damit eine Überabtastung gegeben ist und keine Signalinformationen verloren gehen.

Ausgangsseitig ist der Sigma-Delta-Modulator 2 mit einem Freigabe-Eingang ENABLE des Zählers 10 verbunden. Ein High-Pegel an dem Freigabe-Eingang ENABLE ermöglicht also einen Zählvorgang, bei dem der Zählerstand in dem Zähler 10 inkrementiert wird.

Weiterhin weist der Zähler 10 einen Takteingang CLOCK auf, der mit dem Takteingang 9 verbunden ist und somit ebenfalls durch das Taktsignal CLK angesteuert wird.

Darüber hinaus hat der Zähler einen Rücksetzeingang RESET, der mit einem Steuersignal CTRL beaufschlagt wird, wobei das Steuersignal CTRL an einem Steuereingang 11 anliegt und von einem Mikrocontroller erzeugt. Hierbei ist zu erwähnen, dass das Steuersignal CTRL von dem Mikrocontroller so erzeugt wird, das stets eine konstante Phasenbeziehung zwischen dem Eingangssignal s und dem Steuersignal CTRL besteht. Auf diese Weise wird erreicht, dass jeweils dasselbe Zeitfenster des periodischen Eingangssignals s ausgewertet wird, da der Zähler 10 von dem Steuersignal CTRL zurückgesetzt wird.

Der Zählerstand des Zählers 10 gibt also den zeitlichen Mittelwert des Eingangssignals s während der laufenden Periode der Pulsweitenmodulation wieder.

Ausgangsseitig ist der Zähler 10 mit einem Ausgangsregister 12 verbunden, das den Zählerstand während der nächsten Periode zwischenspeichert. Am Ende der nächsten Periode wird dann der neue Zählerstand in das Ausgangsregister übernommen. Die Übernahme des Zählerstands in das Ausgangsregister 12 wird hierbei durch einen Steuereingang LATCH gesteuert, an dem das Steuersignal CTRL anliegt.

An einem Signalausgang 13 gibt die erfindungsgemäße Schaltungsanordnung schließlich ein Ausgangssignal g aus, das den zeitliche Mittelwert des Eingangssignals s während der letzten Perioden wiedergibt.

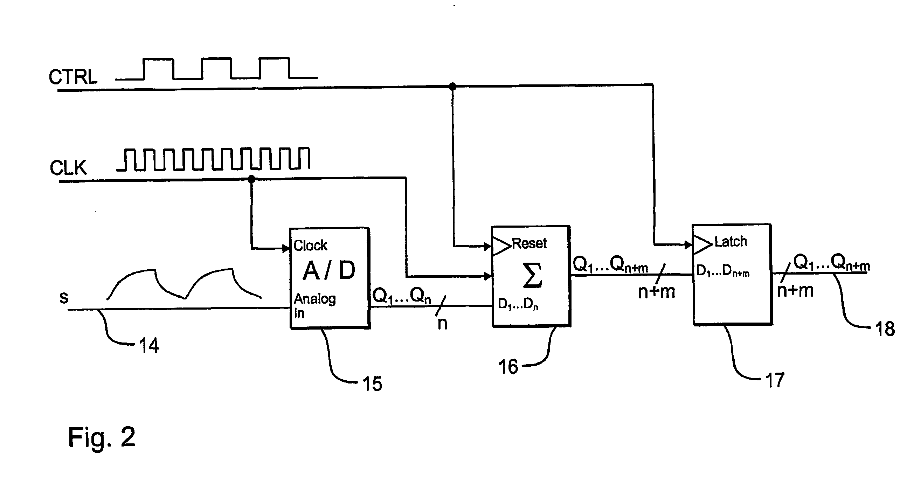

Das in Figur 2 dargestellte Schaltbild zeigte eine nicht beanspruchte Schaltungsanordnung zur Mittelwertbildung, bei der auf einen Sigma-Delta-Modulator verzichtet werden kann.

Diese Schaltungsanordnung weist zur Aufnahme eines auszuwertenden Eingangssignals s einen Signaleingang 14 auf, wobei es sich bei dem Eingangssignal s beispielsweise um ein Stromsignal einer elektronischen Getriebesteuerung in einem PKW handeln kann.

Das Eingangssignal s wird einem Abtasteingang ANALOG IN eines Analog/Digital-Wandlers 15 zugeführt, der aus dem Eingangssignal s ein Digitalsignal Q₁...Qₙ mit einer Breite von n Bit erzeugt.

Der Analog/Digital-Wandler 15 wird hierbei durch ein Taktsignal CLK getaktet, das an einem Takteingang CLOCK des Analog/Digital-Wandlers 15 anliegt und die Abtastrate festlegt.

Das Taktsignal CLK wird von einem Mikrocontroller erzeugt, der zur Vereinfachung nicht dargestellt ist, wobei die Taktfrequenz des Taktsignals CLK wesentlich größer ist als die Grenzfrequenz des bandbegrenzten Eingangssignals s, damit eine Überabtastung gegeben ist und keine Signalinformationen verloren gehen. In diesem Ausführungsbeispiel ist die Taktfrequenz des Taktsignals 32 mal so groß wie die Grenzfrequenz des Eingangssignals s, woraus sich auch ein guter Signal/Rausch-Abstand ergibt.

Ausgangsseitig ist der Analog/Digital-Wandler 15 mit einem Summierer 16 verbunden, der die eingangsseitig aufgenommenen Digitalsignale Q₁...Qₙ aufsummiert und ausgangsseitig ein entsprechendes Digitalsignal Q₁...Qₙ₊ₘ mit einer Wortlänge von n+m Bit ausgibt.

Der Summierer 16 wird hierbei ebenfalls von dem Taktsignal CLK getaktet, so dass sämtliche Digitalsignale Q₁...Qₙ aufsummiert werden, die von dem Analog/Digital-Wandler 15 abgetastet werden.

Weiterhin weist der Summierer 16 einen Rücksetzeingang RESET auf, dem ein Steuersignal CTRL zugeführt wird, das von dem nicht dargestellten Mikrocontroller erzeugt wird. Hierbei ist wiederum zu erwähnen, dass das Steuersignal CTRL von dem Mikrocontroller so erzeugt wird, das stets eine konstante Phasenbeziehung zwischen dem Eingangssignal s und dem Steuersignal CTRL besteht. Auf diese Weise wird erreicht, dass jeweils dasselbe Zeitfenster des periodischen Eingangssignals s ausgewertet wird, da der Summierer 16 von dem Steuersignal CTRL zurückgesetzt wird. Am Ausgang des Summierers 16 erscheint also die Summe Q₁...Qₙ₊ₘ sämtlicher Digitalsignale Q₁...Qₙ während der jeweils laufenden Periode.

Ausgangsseitig ist der Summierer 16 mit einem Ausgangsregister 17 verbunden, das die ermittelte Summe während der nächsten Periode zwischenspeichert. Am Ende der nächsten Periode wird dann der neue Summenwert in das Ausgangsregister 17 übernommen. Die Übernahme des neuen Summenwerts von dem Summierer 16 in das Ausgangsregister 17 wird hierbei durch einen Steuereingang LATCH gesteuert, an dem das Steuersignal CTRL anliegt.

Ausgangsseitig gibt das Ausgangsregister 17 dann an einem Signalausgang 18 ein Ausgangssignal Q₁...Qₙ₊ₘ aus, das die Summe der Abtastwerte während der letzten Periode wiedergibt. Daraus kann dann in Verbindung mit der Anzahl der Abtastungen bzw. der Abtastrate der zeitliche Mittelwert während der letzten Periode berechnet werden.

## Patentansprüche

1. Schaltungsanordnung zur Bestimmung des Mittelwerts eines Eingangssignals (s), mit
einem Signaleingang (1) zur Aufnahme des Eingangssignals (s) und
einem Signalausgang (13) zur Ausgabe eines den Mittelwert des Eingangssignals (s) wiedergebenden Ausgangssignals (g),
wobei zwischen dem Signaleingang (1) und dem Signalausgang (13) zur Mittelwertbildung ein Zähler (10) oder ein Summierer angeordnet ist, der eingangsseitig mit einem Komparator (5) verbunden ist,
wobei in einer Rückkopplungsschleife ein Schaltelement (6) angeordnet ist, das von dem Ausgang des Komparators (5) angesteuert wird und in Abhängigkeit von dem Ausgang des Komparators (5) ein erstes Referenzsignal (Pos_Ref) oder ein zweites Referenzsignal (Neg_Ref) aufschaltet;
**dadurch gekennzeichnet,**
**dass** der Summierer oder der Zähler (10) einen Rücksetzeingang (RESET) aufweist, an dem ein Steuersignal (CTRL) anliegt, wobei das Steuersignal (CTRL) und das Eingangssignal (s) die gleiche Grundfrequenz und/oder die gleiche Phasenlage und/oder eine konstante Phasenbeziehungen zueinander aufweisen.

2. Schaltungsanordnung nach Anspruch 1,
**dadurch gekennzeichnet,**
**dass** der Summierer oder der Zähler (10) eingangsseitig mit einem Sigma-Delta-Modulator (2) verbunden ist.

3. Schaltungsanordnung nach Anspruch 2,
**dadurch gekennzeichnet,**
**dass** der Sigma-Delta-Modulator (2) einen Addierer (3) oder einen Subtrahierer, einen Integrator (4) und einen Komparator (5) sowie eine Rückkopplungsschleife von dem Ausgang des Komparators (5) auf den Eingang des Addierers (3) oder Subtrahierers aufweist.

4. Schaltungsanordnung nach mindestens einem der vorhergehenden Ansprüche,
**dadurch gekennzeichnet,**
**dass** der Summierer oder der Zähler (10) einen Takteingang (CLOCK) aufweist, an dem ein Taktsignal (CLK) mit einer vorgegebenen Taktfrequenz anliegt.

5. Schaltungsanordnung nach Anspruch 4,
**dadurch gekennzeichnet,**
**dass** das Eingangssignal (s) bandbegrenzt ist und eine vorgegebene Grenzfrequenz aufweist, wobei die Taktfrequenz ein ganzzahliges Vielfaches der Grenzfrequenz ist.

6. Schaltungsanordnung nach einem der vorhergehenden Ansprüche,
**dadurch gekennzeichnet,**
**dass** das Taktsignal (CLK) und das Steuersignal (CTRL) eine zeitlich konstante Phasenbeziehung zueinander aufweisen.

7. Schaltungsanordnung nach mindestens einem der vorhergehenden Ansprüche,
**dadurch gekennzeichnet,**
**dass** der Summierer oder Addierer oder der Zähler (10) ausgangsseitig mit einem Ausgangsregister (12) verbunden ist.

8. Schaltungsanordnung nach Anspruch 7,
**dadurch gekennzeichnet,**
**dass** das Ausgangsregister (12) einen Steuereingang (LATCH) zur Steuerung der Datenaufnahme aufweist, wobei an dem Steuereingang (LATCH) das Steuersignal (CTRL) anliegt.

## Revendications

1. Disposition de circuit permettant de déterminer la valeur moyenne d'un signal d'entrée (s), comportant
une entrée de signal (1) permettant de recevoir le signal d'entrée (s) et
une sortie de signal (13) permettant de délivrer un signal de sortie (g) représentant la valeur moyenne du signal d'entrée (s),
dans lequel, entre l'entrée de signal (1) et la sortie de signal (13) est disposé, en vue de la formation de la valeur moyenne, un compteur (10) ou un élément sommateur relié, côté entrée, à un comparateur (5),
dans lequel une boucle de rétroaction est disposé un élément de commutation (6) qui est activé par la sortie du comparateur (5) et qui applique, en fonction de la sortie du comparateur (5), un premier signal de référence (Pos_Ref) ou un deuxième signal de référence (Neg_Ref),
**caractérisée en ce que**
l'élément sommateur ou le compteur (10) présente une entrée de remise à zéro (RESET) à laquelle est appliqué un signal de commande (CTRL), le signal de commande (CTRL) et le signal d'entrée (s) présentant l'un par rapport à l'autre la même fréquence fondamentale et/ou la même position de phase et/ou un rapport de phases constant.

2. Disposition de circuit selon la revendication 1,
**caractérisée en ce que**
l'élément sommateur ou le compteur (10) est relié, côté entrée, à un modulateur delta sigma (2).

3. Disposition de circuit selon la revendication 2,
**caractérisée en ce que**
le modulateur delta sigma (2) présente un additionneur (3) ou un soustracteur, un intégrateur (4) et un comparateur (5) ainsi qu'une boucle de rétroaction reliant la sortie du comparateur (5) à l'entrée de l'additionneur (3) ou du soustracteur.

4. Disposition de circuit selon au moins une des revendications précédentes,
**caractérisée en ce que**
l'élément sommateur ou le compteur (10) présente une entrée d'horloge (CLOCK) à laquelle est appliqué un signal d'horloge (CLK) présentant une fréquence d'horloge prédéfinie.

5. Disposition de circuit selon la revendication 4,
**caractérisée en ce que**
le signal d'entrée (s) est à bande restreinte et présente une fréquence de coupure prédéfinie, la fréquence d'horloge étant un multiple entier de la fréquence de coupure.

6. Disposition de circuit selon l'une des revendications précédentes,
**caractérisée en ce que**
le signal d'horloge (CLK) et le signal de commande (CTRL) présentent l'un par rapport à l'autre un rapport de phases constant dans le temps.

7. Disposition de circuit selon au moins une des revendications précédentes,
**caractérisée en ce que**
l'élément sommateur ou l'additionneur ou le compteur (10) est relié, côté sortie, à un registre de sortie (12).

8. Disposition de circuit selon la revendication 7,
**caractérisée en ce que**
le registre de sortie (12) présente une entrée de commande (LATCH) permettant de commander la réception des données, le signal de commande (CTRL) étant appliqué à l'entrée de commande (LATCH).

## Claims

1. Circuit arrangement for determining the average value of an input signal (s) with
a signal input (1) for receiving the input signal (s) and
a signal output (13) for outputting an output signal (g) indicating the average value of the input signal (s),
a counter (10) or a summing unit being arranged between the signal input (1) and the signal output (13) for averaging, said counter being connected on the input side to a comparator (5),
in which
a switching element (6) is arranged in a feedback loop and activated by the output of the comparator (5) to switch to a first reference signal (Pos_Ref) or a second reference signal (Neg_Ref) as a function of the output of the comparator (5),
**characterised in that**
the summing unit and the counter (10) feature a reset input (RESET) at which a control signal (CTRL) is present, the control signal (CTRL) and the input signal (s) comprising the same basic frequency and/or the same phase position and/or a constant phase relationship to one another.

2. Circuit arrangement according to claim 1,
**characterised in that**
the summing unit or counter (10) is connected on the input side to a sigma-delta modulator (2).

3. Circuit arrangement according to claim 2,
**characterised in that**
the sigma-delta modulator (2) has an adding unit (3) or a subtracting unit, an integrator (4) and a comparator (5) and a feedback loop from the output of the comparator (5) to the input of the adding unit (3) or subtracting unit.

4. Circuit arrangement according to at least one of the preceding claims,
**characterised in that**
the summing unit or counter (10) has a clock input (CLOCK), at which a clock signal (CLK) with a predefined clock frequency is present.

5. Circuit arrangement according to claim 4,
**characterised in that**
the input signal (s) is band-limited and has a predefined limit frequency, the clock frequency being a whole-number multiple of the limit frequency.

6. Circuit arrangement according to one of the preceding claims,
**characterised in that**
the clock signal (CLK) and the control signal (CTRL) have a temporally constant phase relationship to each other.

7. Circuit arrangement according to at least one of the preceding claims,
**characterised in that**
the summing unit or adding unit or counter (10) is connected on the output side to an output register (12).

8. Circuit arrangement according to claim 7,
**characterised in that**
the output register (12) has a control input (LATCH) to control the receipt of data, the control signal (CTRL) being present at the control input (LATCH).
